# EUROPÄISCHE PATENTSCHRIFT

(11) **EP 2 772 125 B1**
(45) Veröffentlichungstag und Bekanntmachung des Hinweises auf die Patenterteilung: **08.11.2017**
(21) Anmeldenummer: 12769969.2
(22) Anmeldetag: 06.09.2012
(51) Int. Cl.: H05K 7/20

(54) **STRÖMUNGSLEITHAUBE ZUR STRÖMUNGSFÜHRUNG VON LUFT**
FLOW-GUIDING HOOD FOR GUIDING A FLOW OF AIR
CAPOT DÉFLECTEUR DESTINÉ À DIRIGER L'ÉCOULEMENT DE L'AIR

(30) Priorität: 28.10.2011 DE 102011117223
(43) Veröffentlichungstag der Anmeldung: 03.09.2014
(73) Patentinhaber: Fujitsu Limited, Kawasaki-shi Kanagawa 211-8588 (JP)
(72) Erfinder: SCHELSHORN, Lorenz, 86179 Augsburg (DE); KÖHLER, Friedrich, 86179 Augsburg (DE)
(74) Vertreter: Epping - Hermann - Fischer
(86) Internationale Anmeldenummer: PCT/EP2012/067415
(87) Internationale Veröffentlichungsnummer: WO 2013/060519

(56) Entgegenhaltungen:
- US-A1- 2004 095 724
- US-A1- 2005 113 016
- US-A1- 2011 014 861
- US-A1- 2011 085 303
- US-B1- 6 330 154

## Beschreibung

Die Erfindung betrifft eine Strömungsleithaube zur Strömungsführung von Luft in einem Computer oder in einem anderen elektronischen Gerät. Solche Geräte enthalten stromverbrauchende elektronische Bauteile, die Wärme erzeugen und daher gekühlt werden müssen. Zu hohe Betriebstemperaturen gefährden beispielsweise die Zuverlässigkeit von Mikroprozessoren oder Speicherchips und verringern deren Lebensdauer.

Strömungsleithauben sind z.B. aus der US 2004/095724 A1, US 2011/085303 A1 und US 2011/014861 A1 bekannt.

Herkömmlich erfolgt die Kühlung mit Hilfe eines Gebläses bzw. Ventilators und wärmeableitenden Strukturen wie beispielsweise Kühlrippen, Luftleithauben oder kompakten wärmeleitfähigen Metallstrukturen in unmittelbarer Nähe zu einzelnen Chips. Eine Luftleithaube ist ein Formteil, das den Luftstrom räumlich begrenzt und dadurch gezielter steuert, sei es für die Abluft von den zu kühlenden Bauteilen weg oder für die Zuluft hin zu den zu kühlenden Bauteilen.

Durch die teilweise sehr komplexen Geometrien der optimierten Luftkanäle werden die zur Luftführung dienenden Elemente herkömmlich als kompakte Spritzgussteile aus Kunststoff hergestellt, wobei die Formgebung mit Hilfe spezieller Kunststoff-Werkzeuge erfolgt (Gussformen usw.). Dabei entstehen einstückige Luftleithauben bzw. Luftleitformteile, die auf die Geometrien und die gewünschten Luftströmungsverläufe im Computer zugeschnitten sind.

Mit zunehmender Komplexität des Innenaufbaus im Computer und/oder mit zunehmender Verfeinerung der gewünschten Luftströmungsverläufe wird eine solche herkömmliche Strömungsleithaube jedoch in der Herstellung zu teuer und zu zeitaufwendig.

Es ist die Aufgabe der vorliegenden Erfindung, eine Strömungsleithaube bereitzustellen, die bei im Wesentlichen unveränderter Wirksamkeit erheblich preisgünstiger herstellbar ist.

Diese Aufgabe wird erfindungsgemäß gelöst durch eine Strömungsleithaube gemäß Anspruch 1. Erfindungsgemäß wird die Strömungsleithaube statt als einstückiges Formteil als Verbund mehrerer Teile aus verschiedenen Materialien hergestellt. Dabei wird ein erstes, flächiges Material wie beispielsweise Blech verwendet, das nach seiner Formgebung (etwa durch Stanzen, Knicken und/oder Verbiegen) einen groben, ungefähren Strömungsverlauf bzw. Strömungsrand vorgibt. Dieses erste Strömungsleitelement wird vorzugsweise so gestanzt, geknickt oder gebogen, dass es aus jeweils ebenen Flächenbereichen mit geraden Kanten bzw. Rändern aufgebaut ist. An solch einem ersten Formteil sind weitere Formteile aus dem zweiten Material, die zur Feinregulierung des Strömungsverlaufs dienen, besonders leicht anbringbar. Das zweite Material ist aus einem leichten Volumenmaterial, insbesondere aus Kunststoffschaum gebildet.

Ein Ausführungsbeispiel wird nachstehend exemplarisch anhand der Figuren beschrieben. Es zeigen:
- Figur 1: ein Ausführungsbeispiel einer Strömungsleithaube und
- Figur 2: einen Computer mit einer Strömungsleithaube im Innern.

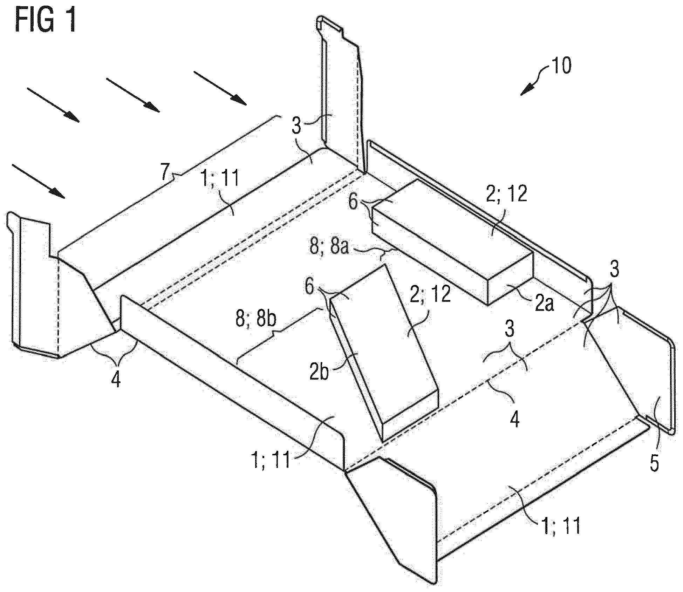

Figur 1 zeigt in perspektivischer Ansicht ein Ausführungsbeispiel einer Strömungsleithaube 10 zur Strömungsführung von Luft in einem Computer oder einem anderen elektronischen Gerät. Die Strömungsleithaube 10 ist aus mehreren Einzelteilen zusammengesetzt. Ein erstes Strömungsleitelement 1, welches einen Hauptströmungskanal 7 vorgibt, ist aus einem flächigen ersten Material 11 geformt, beispielsweise aus Blech, Pappe oder aus einem Kunststoff. Der Hauptströmungskanal 7 führt in Figur 1 von links nach rechts über die perspektivisch dargestellte Strömungsleithaube 10 hinweg; dabei wird der Hauptströmungskanal 7 zumindest in einer Richtung (etwa nach unten hin) durch das erste Strömungsleitelement 1 begrenzt. In einer anderen Richtung (etwa nach oben hin) kann der Hauptströmungskanal 7 beispielsweise durch weitere Elemente im Innern des Computers begrenzt werden; dies ist jedoch nicht unbedingt erforderlich.

Vorzugsweise ist das erste Strömungsleitelement 1 entlang mehrerer vorzugsweise gerader Kanten 4 geknickt, gestanzt oder auf sonstige Weise verbogen, wodurch eine Mehrzahl ebener, d.h. planarer Teilabschnitte 3 entsteht. So lässt sich das erste Strömungsleitelement 1 auf einfache Weise in die gewünschte Form bringen und ist auch anschließend besonders leicht weiterbearbeitbar. Dazu werden ein oder mehrere zweite Strömungsleitelemente 2; 2a, 2b bereitgestellt, die zur Feinjustierung des Strömungsverlaufs dienen. In Figur 1 sind beispielhaft zwei solche zweite Strömungsleitelemente 2a, 2b dargestellt. Sie bestehen aus einem zweiten Material 12, welches vorzugsweise ein Volumenmaterial ist, etwa eine kompakte Masse oder ein Schaum. Insbesondere ein Schaum erscheint vorteilhaft, da er ohne großen Materialverbrauch hergestellt und auf einfache Weise geformt, etwa geschnitten oder gesägt werden kann. Die spezielle Ausführungsform der Figur 1, wonach das erste Strömungsleitelement 1 ausschließlich oder überwiegend durch ebene Flächen bzw. Flächenstücke begrenzt ist, hat in Verbindung mit den zweiten Strömungsleitelementen 2 den besonderen Vorteil, dass letztere geometrisch besonders einfach ausgeformt werden können und besonders einfach mit dem ersten Strömungsleitelement 1 verbunden werden können; im einfachsten Fall durch ganzflächiges Verkleben einer oder mehrerer ebener Flächen 6 des jeweiligen zweiten Strömungsleitelements 2 mit einem ebenen Teilabschnitt 3 des ersten Strömungsleitelements 1. Durch die beispielsweise auf der Innenseite des ersten Strömungsleitelements 1 aufgeklebten zweiten Strömungsleitelemente 2; 2a, 2b lässt sich zum Beispiel ein Hauptströmungskanal 7 einengen, lokal einengen oder in mehrere Teilströmungskanäle 8; 8a, 8b aufteilen. Es können auch mehrere zweite Strömungsleitelemente aufeinander geklebt oder anderweitig miteinander verbunden werden. Dessen ungeachtet gibt das erste Strömungsleitelement 1 aus dem flächigen Material einen Hauptströmungskanals 7 vor, der durch die zweiten Strömungsleitelemente 2 weiter ausgeformt wird. Somit dienen sowohl das erste Strömungsleitelement 1 als auch die zweiten Strömungsleitelemente 2; 2a, 2b zur aktiven Strömungsführung von Luft oder eines anderen gasförmigen Mediums. Vorzugsweise befinden sich sämtliche zweiten Strömungsleitelemente 2 auf derselben Seite des flächigen Materials 11, aus dem das erste Strömungsleitelement 1 gebildet ist; die mit den zweiten Strömungsleitelementen 2 versehene Oberfläche 5 des ersten Strömungsleitelements ist dessen Innenseite, die den Strömungskanal umgibt oder teilweise umgibt.

Die hier beschriebene Strömungsleitstruktur bzw. Strömungsleithaube 10 eignet beispielsweise, um einen Luftstrom zwischen einem Ventilator und einem oder mehreren mit Kühlluft zu kühlenden Baueinheiten eines Computers zu versorgen. Alternativ kann mit solch einer Strömungsleithaube 10 die Abluft von einem oder mehreren Baueinheiten abgeleitet werden. Ebenso kann mit Hilfe eines Ventilators Luft von den Baueinheiten angesaugt werden, die zunächst durch die Strömungsleithaube strömt, bevor sie die Bauteile oder den Ventilator erreicht.

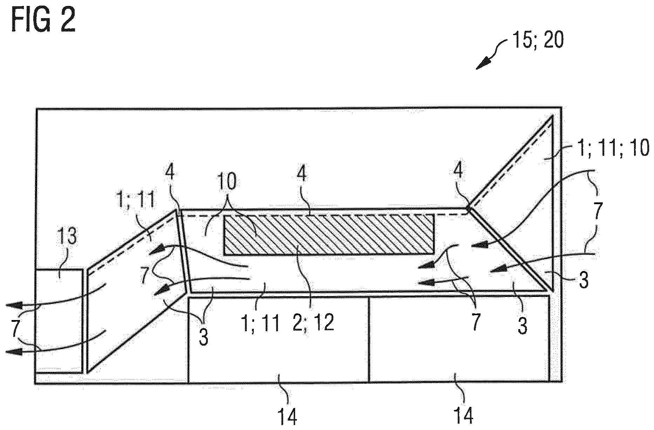

Figur 2 zeigt schematisch einen Querschnitt eines Computers 20 oder eines sonstigen elektronischen Geräts 15, welches mit einer Strömungsleithaube 10 gemäß der vorliegenden Anmeldung ausgestattet ist. In der Querschnittsansicht sind zwei zu kühlende Baueinheiten 14 des Computers und ein Ventilator 13 angedeutet. Im Computer 20 ist eine Strömungsleithaube 10 verbaut, die einen Hauptströmungskanal 7 einengt und ihn im Bereich nahe der zu kühlenden Baueinheite 14 verstärkt, wie anhand des durch Pfeile angedeuteten Strömungsverlaufs erkennbar ist.

Die Strömungsleithaube 10 umfasst ein erstes Strömungsleitelement 1 aus einem ersten Material 11 wie beispielsweise einem Blech und mindestens ein zweites Strömungsleitelement 2 aus einem zweiten Material 12, beispielsweise einem Kunststoffschaum. Das zweite Strömungsleitelement 2 ist beispielsweise mit der (nach unten weisenden, aber oben angeordneten) Oberseite des mittleren Abschnitts des ersten Strömungsleitelements 1 verbunden. Die Höhe und der Verlauf der Seitenwände des ersten Strömungsleitelements 1 definieren innerhalb der Zeichenebene und senkrecht zur Zeichenebene das Volumen, das für den Hauptströmungskanal 7 zur Verfügung steht. Das zweite Strömungsleitelement ist beispielsweise quaderförmig geformt oder anderweitig durch ebene Flächen begrenzt und schnürt den Strömungskanal 7 noch weiter ein. Dadurch ist in unmittelbarer Nähe zu den Baueinheiten 14 die Strömungsgeschwindigkeit der Luft noch größer. Die hier beschriebene Strömungsleithaube ist erheblich einfacher herstellbar und preisgünstiger als ein einstückiges, ausgeformtes Spritzgußteil aus Kunststoff, und trotz einfachster Grundformen lassen sich Strömungsverläufe optimieren, etwa durch schräge Begrenzungsflächen des ersten und/oder zweiten Formteils oder durch gekrümmte Oberflächen insbesondere von zweiten Formteilen aus dem Volumenmaterial.

Auf diesem Prinzip aufbauend lässt sich der Strömungsverlauf durch Verfeinerung der Formgebung des ersten und zweiten Strömungsleitelements sowie durch Hinzunahme zusätzlicher Strömungsleitelemente 2 aus dem zweiten Material 12 weiter optimieren.

### Bezugszeichenliste

- 1: erstes Strömungsleitelement
- 2; 2a, 2b: zweites Strömungsleitelement
- 3: ebener Teilabschnitt
- 4: gerade Kante
- 5: erste Oberfläche
- 6: ebene Fläche
- 7: Hauptströmungskanal
- 8; 8a, 8b: Teilströmungskanal
- 10: Strömungsleithaube
- 11: erstes Material
- 12: zweites Material
- 13: Ventilator
- 14: Baueinheit
- 15: elektronisches Gerät
- 20: Computer

## Patentansprüche

1. Strömungsleithaube (10) zur Strömungsführung von Luft in einem Computer (15) oder einem anderen elektronischen Gerät (20),
wobei die Strömungsleithaube (10) aus mehreren Einzelteilen zusammengesetzt ist und mindestens Folgendes umfasst:
- ein zur Strömungsführung dienendes erstes Strömungsleitelement (1) aus einem flächigen ersten Material (11) und
- mindestens ein ebenfalls zur Strömungsführung dienendes zweites Strömungsleitelement (2) aus einem anderen, zweiten Material (12),
wobei das zweite Strömungsleitelement (2) an dem ersten Strömungsleitelement (1) aufliegt und/oder an ihm befestigt ist, **dadurch gekennzeichnet, dass**
das zweite Strömungsleitelement (2) aus einem leichten Volumenmaterial aus Kunststoffschaum gebildet ist.

2. Strömungsleithaube nach Anspruch 1,
**dadurch gekennzeichnet, dass**
das zweite Strömungsleitelement (2) so zugeschnitten, gestanzt oder anderweitig ausgeformt ist, dass es überwiegend durch ebene Flächen (6) begrenzt ist.

3. Strömungsleithaube nach einem der Ansprüche 1 oder 2,
**dadurch gekennzeichnet, dass**
jedes zweite Strömungsleitelement (2) eine oder mehrere ebene Flächen (6) aufweist, die an dem ersten Strömungsleitelement (1) befestigt, insbesondere ganzflächig angeklebt ist.

4. Strömungsleithaube nach einem der Ansprüche 1 bis 3,
**dadurch gekennzeichnet, dass**
das flächige Material (11) des ersten Strömungsleitelements (1) knickbar, verbiegbar oder auf sonstige Weise zu mehreren ebenen Teilabschnitten (3) verformbar ist.

5. Strömungsleithaube nach einem der Ansprüche 1 bis 4,
**dadurch gekennzeichnet, dass**
das flächige Material (11) des ersten Strömungsleitelements (1) ein Kunststoffmaterial, insbesondere eine Kunststofffolie, oder ein Blech oder Pappe ist.

6. Strömungsleithaube nach einem der Ansprüche 1 bis 5,
**dadurch gekennzeichnet, dass**
das erste Strömungsleitelement (1) ein gestanztes Formteil ist.

7. Strömungsleithaube nach einem der Ansprüche 1 bis 6,
**dadurch gekennzeichnet, dass**
das erste Strömungsleitelement (1) so geformt ist, dass es in eine Mehrzahl jeweils ebener Teilabschnitte (3) unterteilt ist.

8. Strömungsleithaube nach Anspruch 7,
**dadurch gekennzeichnet, dass**
die verschiedenen ebenen Teilabschnitte (3) des ersten Strömungsleitelements (1) unterschiedlich orientiert sind und durch Knicke, Falze, Perforationen, Stanzungen oder anderweitig gebildete gerade Kanten (4) voneinander abgegrenzt sind.

9. Strömungsleithaube nach einem der Ansprüche 1 bis 8,
**dadurch gekennzeichnet, dass**
das erste Strömungsleitelement (1) so geformt ist, dass es auf einer ersten Oberfläche (5) einen Hauptströmungskanal (7) begrenzt, und dass ein oder mehrere zweite Strömungsleitelemente (2) auf dieser Oberfläche (5) des ersten Strömungsleitelements (1) an ihm befestigt sind.

10. Strömungsleithaube nach einem der Ansprüche 1 bis 9,
**dadurch gekennzeichnet, dass**
ein oder mehrere zweite Strömungsleitelemente (2) auf derselben Seite des ersten Strömungsleitelements (1) so angeordnet sind, dass sie einen Hauptströmungskanal (7) einengen, lokal einengen oder in mehrere Teilströmungskanäle (8; 8a, 8b) aufteilen.

11. Strömungsleithaube nach einem der Ansprüche 1 bis 10,
**dadurch gekennzeichnet, dass**
jedes der zweiten Strömungsleitelemente (2; 2a, 2b) als Block, der ausschließlich durch ebene Flächen (6) begrenzt ist, aus dem Volumenmaterial (12) geschnitten oder geformt ist.

12. Elektronisches Gerät (15), insbesondere Computer (20), mit einer Strömungsleithaube (10) nach einem der Ansprüche 1 bis 11.

## Claims

1. A flow-guiding hood (10) for guiding a flow of air in a computer (15) or another electronic device (20),
wherein the flow-guiding hood (10) is composed of multiple individual parts and comprises at least the following:
- a first flow-guiding element (1) made of a planar first material (11) and serving for channeling the flow, and
- at least one second flow-guiding element (2) made of a different, second material (12) and likewise serving for channeling the flow,
wherein the second flow-guiding element (2) rests on and/or is attached to the first flow-guiding element (1), **characterized in that**
the second flow-guiding element (2) is formed of a light volume material of foamed plastic.

2. The flow-guiding hood according to claim 1, **characterized in that**
the second flow-guiding element (2) is cut to size, punched or otherwise shaped such that it is delimited predominantly by flat faces (6).

3. The flow-guiding hood according to one of claims 1 or 2, **characterized in that** each second flow-guiding element (2) comprises one or more flat faces (6) which are fixed, in particular bonded over the entire surface to the first flow-guiding element (1).

4. The flow-guiding hood according to one of claims 1 to 3, **characterized in that** the planar material (11) of the first flow-guiding element (1) is foldable, bendable or deformable in another way to form a plurality of flat segments (3).

5. The flow-guiding hood according to one of claims 1 to 4, **characterized in that** the planar material (11) of the first flow-guiding element (1) is a plastic material, in particular a plastics sheet or a sheet metal or cardboard.

6. The flow-guiding hood according to one of claims 1 to 5, **characterized in that** the first flow-guiding element (1) is a punched molded part.

7. The flow-guiding hood according to one of claims 1 to 6, **characterized in that** the first flow-guiding element (1) is shaped in such a way that it is divided into a plurality of in each case flat segments (3).

8. The flow-guiding hood according to claim 7, **characterized in that** the various flat segments (3) of the first flow-guiding element (1) are differently oriented and are separated from each other by bends, folds, perforations, punchings or by straight edges (4) formed otherwise.

9. The flow-guiding hood according to one of claims 1 to 8, **characterized in that**
the first flow-guiding element (1) is shaped in such a way that on a first surface (5) it delimits a main flow channel (7), and **in that** one or more second flow-guiding elements (2) are attached to it on this first surface (5) of the first flow-guiding element (1).

10. The flow-guiding hood according to one of claims 1 to 9, **characterized in that**
one or more second flow-guiding elements (2) are arranged on the same side of the first flow-guiding element (1) such that they constrict, locally constrict or divide a main flow channel (7) into a plurality of part-flow channels (8; 8a, 8b).

11. The flow-guiding hood according to one of claims 1 to 10, **characterized in that**
each of the second flow-guiding elements (2; 2a, 2b) is cut or shaped from the volume material (12) as a block exclusively delimited by flat faces (6).

12. An electronic device (15), in particular a computer (20), comprising the flow-guiding hood (10) according to one of claims 1 to 11.

## Revendications

1. Capot de guidage de flux (10) destiné à guider le flux d'air dans un ordinateur (15) ou un autre appareil électronique (20),
le capot de guidage de flux (10) étant composé de plusieurs pièces individuelles et comprenant au moins les éléments suivants :
- un premier élément de guidage de flux (1) servant au guidage du flux, constitué d'une première matière (11) plate, et
- au moins un deuxième élément de guidage de flux (2) servant également au guidage du flux, constitué d'une deuxième autre matière (12),
le deuxième élément de guidage de flux (2) reposant sur le premier élément de guidage de flux (1) et/ou étant fixé sur lui,
**caractérisé en ce que**
le deuxième élément de guidage de flux (2) est formé dans une matière volumique légère en mousse plastique.

2. Capot de guidage de flux selon la revendication 1,
**caractérisé en ce que**
le deuxième élément de guidage de flux (2) est découpé, estampé ou formé d'une autre façon de manière à ce qu'il soit principalement limité par des surfaces planes (6).

3. Capot de guidage de flux selon l'une quelconque des revendications 1 ou 2,
**caractérisé en ce que**
chaque deuxième élément de guidage de flux (2) présente une ou plusieurs surfaces planes (6), laquelle est fixée sur le premier élément de guidage de flux (1), notamment y collée sur toute sa surface.

4. Capot de guidage de flux selon l'une quelconque des revendications 1 à 3,
**caractérisé en ce que**
la matière plate (11) du premier élément de guidage de flux (1) peut être pliée, cintrée ou déformée d'une autre manière en plusieurs sections partielles planes (3).

5. Capot de guidage de flux selon l'une quelconque des revendications 1 à 4,
**caractérisé en ce que**
la matière plate (11) du premier élément de guidage de flux (1) est une matière plastique, notamment une feuille plastique, ou une tôle ou du carton.

6. Capot de guidage de flux selon l'une quelconque des revendications 1 à 5,
**caractérisé en ce que**
le premier élément de guidage de flux (1) est une pièce moulée estampée.

7. Capot de guidage de flux selon l'une quelconque des revendications 1 à 6,
**caractérisé en ce que**
le premier élément de guidage de flux (1) est formé de manière à être divisé en une pluralité de sections partielles (3) respectivement planes.

8. Capot de guidage de flux selon la revendication 7,
**caractérisé en ce que**
les différentes sections partielles (3) planes du premier élément de guidage de flux (1) sont orientées différemment et sont délimitées les unes des autres par des coudes, des plis, des perforations, des estampages ou des bords (4) rectilignes formés d'une autre manière.

9. Capot de guidage de flux selon l'une quelconque des revendications 1 à 8,
**caractérisé en ce que**
le premier élément de guidage de flux (1) est formé de manière à délimiter un canal de flux principal (7) sur une première surface (5), et **en ce qu'**un ou plusieurs deuxièmes éléments de guidage de flux (2) sont fixés sur lui sur cette surface (5) du premier élément de guidage (1).

10. Capot de guidage de flux selon l'une quelconque des revendications 1 à 9,
**caractérisé en ce que**
un ou plusieurs deuxièmes éléments de guidage de flux (2) sont disposés sur le même côté du premier élément de guidage de flux (1) de manière à ce qu'ils rétrécissent un canal de flux principal (7), le rétrécissent localement ou le divisent en plusieurs canaux de flux partiel (8, 8a, 8b).

11. Capot de guidage de flux selon l'une quelconque des revendications 1 à 10,
**caractérisé en ce que**
chacun des deuxièmes éléments de guidage de flux (2 ; 2a, 2b), en tant que bloc qui est délimité uniquement par des surfaces planes (6), est découpé ou formé à partir de la matière volumique (12).

12. Appareil électronique (15), notamment ordinateur (20), comprenant un capot de guidage de flux (10) selon l'une quelconque des revendications 1 à 11.
